# EUROPEAN PATENT SPECIFICATION

(11) **EP 2 727 185 B1**
(45) Date of publication and mention of the grant of the patent: **14.03.2018**
(21) Application number: 11868551.0
(22) Date of filing: 28.06.2011
(51) Int. Cl.: H01R 4/38, H05K 1/18, H05K 3/30, H05K 3/32, H01R 12/70, H05K 5/00

(54) **A VEHICLE SAFETY ARRANGEMENT**
FAHRZEUGSICHERHEITSANORDNUNG
AGENCEMENT DE SÉCURITÉ DE VÉHICULE

(43) Date of publication of application: 07.05.2014
(73) Proprietor: Autoliv Development AB, 447 83 Vårgårda (SE)
(72) Inventor: HUGAUD, Pascal, F-78600 Le Mesnil le Roi (FR)
(74) Representative: Sandstedt, Jonas Sven James
(86) International application number: PCT/SE2011/050853
(87) International publication number: WO 2013/002684

(56) References cited:
- EP-A1- 2 031 947
- EP-A2- 1 883 282
- EP-B1- 0 752 738
- WO-A1-2009/010704
- WO-A1-2009/010705
- WO-A1-2009/010705
- US-A- 6 163 460

## Description

The present invention relates to an electronic unit comprising a housing and a circuit board arranged to be mounted to the housing. The housing in turn comprises a first wall and a first electrical component mounted onto the first wall. The first electrical component has at least one electrically conducting contact pin. The electronic unit further comprises a supporting element for said contact pin.

In several technical fields, for instance in the control of electrical systems on board a motor vehicle, it is desirable to provide a sealed non-conductive (e.g. plastic) housing containing a PCB, onto which are mounted several electrical components. An electrical unit of this type is disclosed in US 6163460.

In many cases, one of the electrical components that must be housed within the unit is a large, relatively heavy capacitor. While most of the electronic components are surface-mounted on the PCB, it is preferred not to attach a bulky capacitor to the PCB directly, since the weight of the capacitor is likely to break or distort the substrate or electrically conducting tracks of the PCB. It has therefore been proposed to attach large components such as capacitors to an interior surface of the housing of the unit, so that the weight of the component places no mechanical stress on the PCB itself, and to connect the component electrically to the PCB by one or more wires, cables or similar.

However, when assembling a unit of this type, it is preferred not to carry out such soldering operations, since they would be undesirable due to cost and efficiency.

In WO 2009/010704 it is descried how intermediate electrical connectors in holders are positioned such that conductive communication is provided between the PCB and conductive contact pins of a component, such as a relatively large and heavy capacitor attached to a housing of an electronic unit. The electrical connectors are press-fitted into the PCB in order to achieve the desired stability.

WO 2009/010705 discloses an electrical component having at least one conductive contact pin, a circuit board having an aperture and being provided with a contact arrangement having at least one contact surface. The contact pin may pass through the aperture in the circuit board so that the connection region thereof is received and retained by the contact arrangement.

However, the need for press-fitting requires special electrical connectors and tools, and certain intermediate electrical connectors in holders are required.

There is thus a need for an electronic unit comprising a PCB and a housing, where an electrical component is mounted to the housing and connection is made between the component and the PCB in a less complicated manner than presented in prior art.

It is an object of the present invention to provide an electronic unit comprising an PCB and a housing, where an electrical component is mounted to the housing and connection is made between the component and the PCB in a less complicated manner than presented in prior art.

This object is achieved by means of an electronic unit comprising a housing and a circuit board arranged to be mounted to the housing. The housing in turn comprises a first wall and a first electrical component mounted onto the first wall. The first electrical component has at least one electrically conducting contact pin. The electronic unit further comprises a supporting element for said contact pin. The supporting element is arranged to support said contact pin such that a direct electrical contact is established between said contact pin and at least one corresponding electrically conducting surface arranged on the circuit board when the circuit board is mounted to the housing.

According to an example, the electronic unit further comprises a mounting means, for example in the form of a screw or a rivet, arranged for clamping said contact pin against said electrically conducting surface.

In the case of the first electrical component comprising two contact pins, the mounting means may be arranged for being positioned between the contact pins.

The mounting means may also be arranged for fixing a lid to the housing.

According to another example, each contact pin comprises at least one bend.

Further examples are apparent in the dependent claims.

A number of advantages are obtained by means of the present invention, for example the electrical component may be attached to the circuit board in a secure manner with a minimum of components and process steps.

### Brief description of the drawings

The present invention will now be described more in detail with reference to the appended drawings, where:
- Figure 1: shows a schematical perspective view of an electronic unit;
- Figure 2: shows a schematical perspective view of a capacitor about to be mounted in a housing according to the present invention;
- Figure 3: shows a schematical perspective view of a capacitor mounted in a housing according to the present invention;
- Figure 4: shows a schematical perspective view of a printed circuit board about to be mounted to the capacitor and the housing;
- Figure 5: shows a schematical side view of the items shown in Figure 4;
- Figure 6: shows a schematical side view of the printed circuit board mounted to the capacitor and the housing;
- Figure 7: shows a schematical side view of a first alternative capacitor mounting;
- Figure 8: shows a schematical side view of a second alternative capacitor mounting; and
- Figure 9: shows a schematical side view of a third alternative capacitor mounting.

### Detailed description

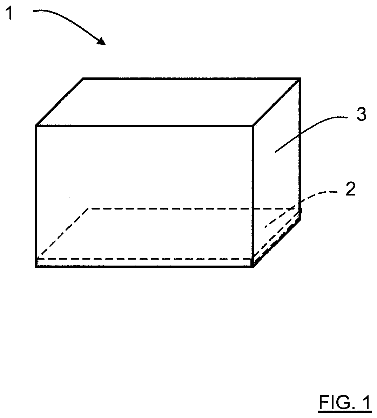

With reference to Figure 1, an electronic unit 1 is shown, the electronic unit 1 comprising a printed circuit board 2 (PCB) and a housing 3. The electronic unit 1 may be a part of a control system in a vehicle and comprises electronic components and connectors, although these are not shown in this simplified view. The PCB 2 is of an ordinary kind, comprising conductive tracks and component connections. The PCB 2 may have one or several conductive layers, where some layers may comprise conductive tracks and some layers may comprise ground planes.

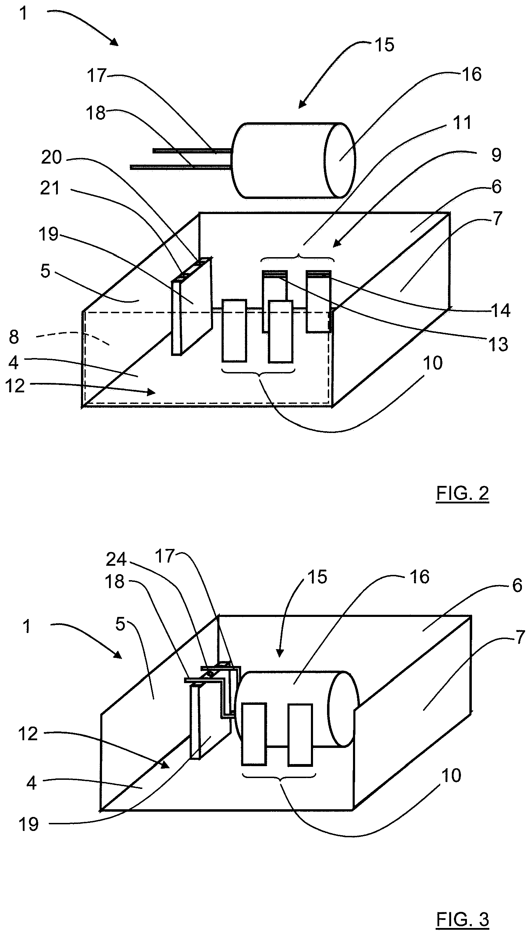

With reference to Figure 2, the housing 1 is shown having a first wall 4, facing downwards in Figure 2, and corresponding side walls 5, 6, 7, 8 to define an inner space having a substantially rectangular cross-section. For reasons of clarity, one side wall 8, shown transparent and indicated with dashed lines, will not be shown in the rest of the description, although it should be assumed to be present.

The housing 3 is formed from a sturdy, insulating material such as a plastics material.

There is a mounting arrangement 9 comprising a first clip pair 10 and a second clip pair 11, the clip pairs 10, 11 projecting from an inner surface 12 of the first wall 4 in an opposing manner. Each clip in the clip pairs 10, 11 comprises a substantially rectangular body, which is arranged to be generally perpendicular to the inner surface 12, and each of which has a protruding lip 13, 14 at or near the free end thereof, which protrudes towards the other one of the clip pairs 10, 11. Only the lips 13, 14 of the first clip pair 10 are shown, the other clip pair 11 having corresponding lips.

The clip pairs 10, 11 are preferably formed from a sturdy, resilient, non-conductive material, and may be formed integrally with the first wall 4. A capacitor 15 is shown and is of a type which incorporates a relatively large, substantially cylindrical body 16 and has two contact pins 17, 18 protruding therefrom, each of the contact pins 17, 18 comprising a metal lead having a round or rectangular cross-section.

The mounting arrangement 9 is adapted to receive and retain the capacitor 15. The dimensions and spacing of the two clip pairs 10, 11 are such that the body 16 of the capacitor 15 may be pushed between them, contacting the lips 13, 14 thereof so that the clip pairs 10, 11 are deflected and forced apart, and then allowed to return to their initial positions once the body 16 of the capacitor 15 has been pushed past the lips 13, 14. The capacitor 15 is then held in place, as shown in Figure 3, being trapped between the inner surface 12 and the clip pairs 10, 11, and being prevented from becoming detached from the mounting arrangement 9 by the protruding lips 13, 14 of the two clip pairs 10, 11, since the gap between the protruding lips 13, 14 is less than the width of the body 16 of the capacitor 15.

When the capacitor 15 is mounted as shown in Figure 3, the contact pins 17, 18 are arranged to rest on a supporting element 19 attached to the inner surface 12. The supporting element 19 is preferably formed from a robust, non-conductive material, and comprises a first groove 20 and a second groove 21, the grooves 20, 21 being arranged to receive the contact pins 17, 18.

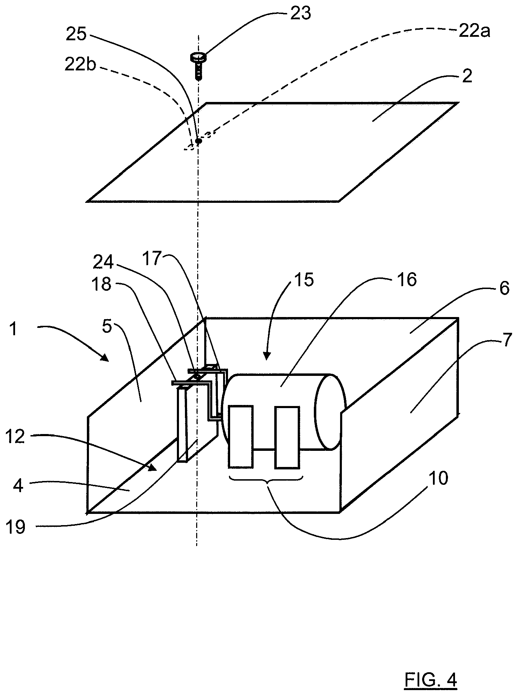

According to the present invention, with reference also to Figure 4, Figure 5 and Figure 6, the supporting element 19 is arranged to support contact pins 17, 18 such that a direct electrical contact is established between contact pins 17, 18 and corresponding contact surfaces 22a, 22b arranged on the PCB 2 when the circuit board 2 is mounted to the housing 3. The contact surfaces 22a, 22b are here in the form of a pad, being formed from one of a plurality of conducting tracks formed on the PCB 2. Each contact surface 22a, 22b may be in the form of a copper surface, but which also may be coated with for example gold, silver or a tin film.

In order to accomplish such a direct electrical contact between the contact pins 17, 18 and the contact surfaces 22a, 22b of the PCB 2, the grooves 20, 21 are positioned such that the contact pins 17, 18 are brought into contact with the corresponding contact surfaces 22a, 22b when the PCB 2 is mounted to the housing 3. Since the position of the contact pins 17, 18, when emerging from the body 16 of the capacitor 15, are closer to the first side 4 than the grooves 20, 21, the contact pins 17, 18 are bent such that a part of respective contact pin 17, 18 is brought to engage the corresponding groove 20, 21.

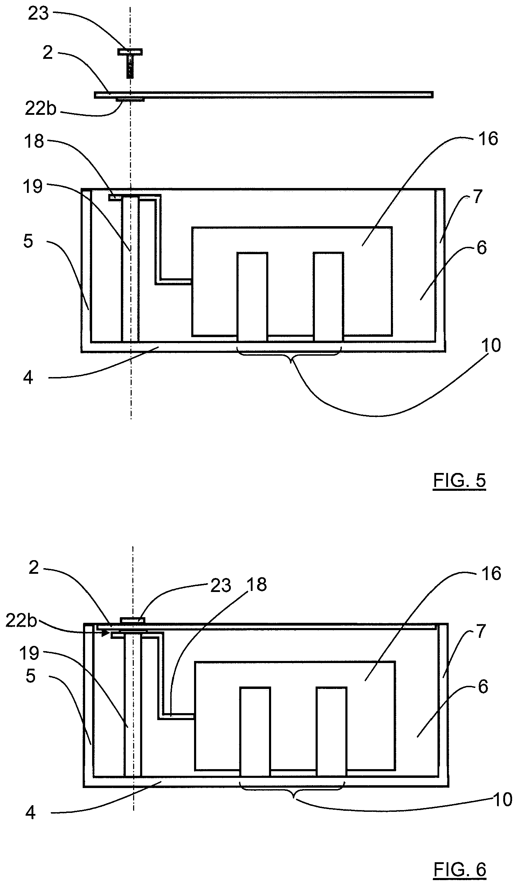

With reference to Figure 4, where the PCB 2 is about to be mounted to the housing 3, it is shown how a screw 23 is used to ensure a reliable contact between the contact surfaces 22a, 22b of the PCB 2 and the contact pins 17, 18. The screw 23 is arranged to be screwed into a corresponding screw hole 24 in the supporting element 19 via an aperture 25 in the PCB 2. The screw hole 24 is positioned between the grooves 20, 21 such that a firm pressure is obtained between the PCB 2 and the contact pins 17, 18 when the screw 23 is fitted as shown in Figure 5 and Figure 6.

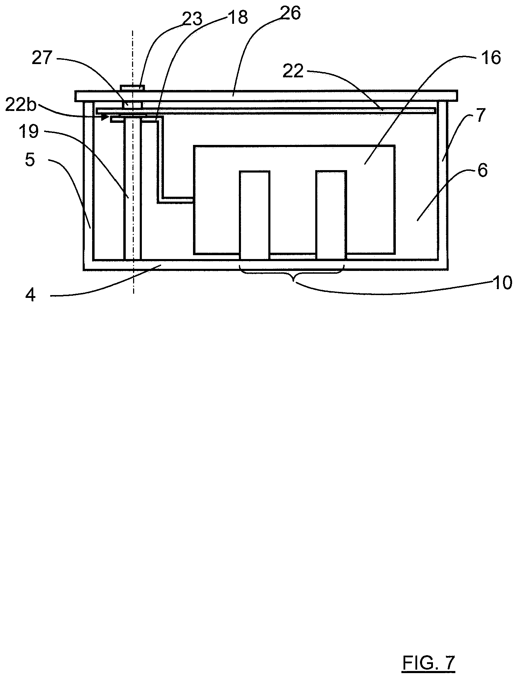

With reference to Figure 7, showing a first alternative, a lid 26 may be fitted to cover the PCB 2 such that it is sealed within the housing 3, the lid 26 constituting a sixth wall of the housing 3 when mounted. The screw 23 may thus be arranged to hold the lid 26 as well as the PCB 2, in Figure 7 a washer 27 is shown as a pressure transferring element from the lid 26 to the PCB 2 since there should be a space between the lid 26 and the PCB 2. Alternatively, the washer 27 could instead be formed as an integral part of the lid 26, or instead of a washer there could be an indent in the lid 26 where the screw 23 is inserted.

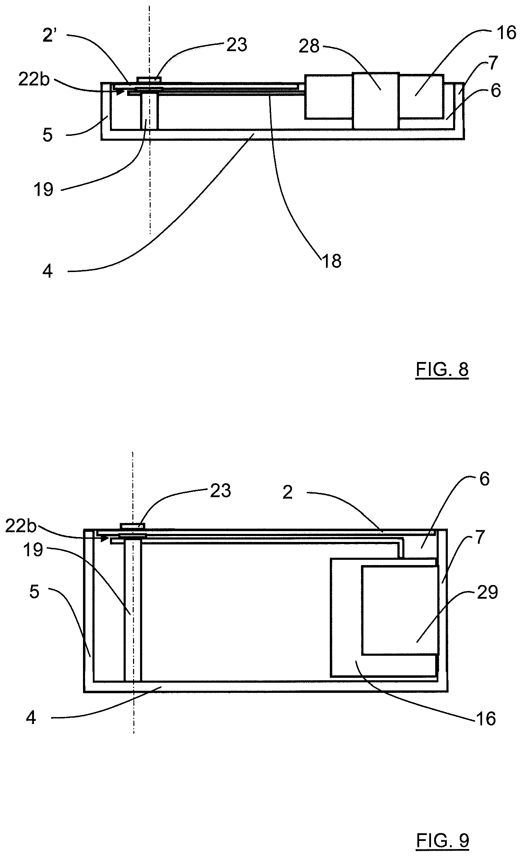

With reference to Figure 8, showing a second alternative, the capacitor 15 is inserted between one clip 28 on each side, where the PCB 2' is formed such that it does not cover the body 16, such that no bends are required for the contact pins 17, 18.

With reference to Figure 9, showing a third alternative, the capacitor 15 is inserted between one clip 29 on each side, where the first wall 4' is arranged to be perpendicular to the PCB 2 when mounted. This means that the capacitor is arranged such that only one bend is required for the contact pins 17, 18.

The present invention is not limited to the above, but may vary freely within the scope of the appended claims. For example, the capacitor 15 may be mounted to any suitable mounting arrangement in the housing 3, comprising any number and type of holders. The capacitor 15 may even be glued or stuck to the housing 3 in any other convenient way. As mentioned in the example above with reference to Figure 9, only one clip 29 at each side is used.

The capacitor 15 may generally be any type of component having at least one contact pin 17, 18 that is intended to be electrically connected to the PCB 2.

The first wall 4 may be any of the walls in the housing 3. In the example above, it is a top or bottom wall with surrounding side walls, and may then also form a removable lid. If the first wall 4 is such a lid of the housing 3, the connection between the PCB 2 and the capacitor 15 may be formed when the lid 4 is placed on the housing 3 to form a sealed unit.

There may be less walls in the housing than shown.

The electronic unit 1 may have any suitable shape, for example cylindrical, where the electric component in that case is positioned on a flat circular wall.

The PCB may be any sort of suitable circuit board, being made from for example glass fiber or any other suitable plastic material.

All materials mentioned are only to be regarded as examples of suitable materials.

A number of electrical components may be attached to the housing and mounted to the PCB in the same way as the
capacitor shown in the examples above, that capacitor generally constituting a first electrical component.

The may be more than the single screw 23 shown in the examples, and the screw 23 may generally be constituted by any suitable mounting means such as a rivet.

The contact surfaces 22a, 22b may be formed from the etched conductor paths on the PCB 2, or may be attached to the PCB 2 afterwards, for example by means of screen printing. All conductor paths on the PCB 2 may be screen printed.

## Claims

1. An electronic unit (1) comprising a housing (3) and a circuit board (2) arranged to be mounted to the housing (3), the housing (3) in turn comprising a first wall (4) and a first electrical component (15) mounted onto an inner surface (12) of the first wall (4), the first electrical component (15) having at least one electrically conducting contact pin (17, 18), the housing (3) further comprising a supporting element (19) for said contact pin (17, 18) **characterized in that** the supporting element (19) is attached to the inner surface (12) and comprises at least one groove (20, 21) arranged for receiving said contact pin (17, 18), where the supporting element (19) is arranged to support said contact pin (17, 18) such that a direct electrical contact is established between said contact pin (17, 18) and at least one corresponding electrically conducting surface (22a, 22b) arranged on the circuit board (2) when the circuit board (2) is mounted to the housing (3), where the electronic unit (1) further comprises a mounting means (23) arranged for clamping said contact pin (17, 18) against said electrically conducting surface (22a, 22b).

2. An electronic unit (1) according to claim 1, **characterized in that** the first electrical component (15) comprises two contact pins (17, 18) where the mounting means (23) is arranged for being positioned between the contact pins (17, 18).

3. An electronic unit (1) according to any one of the claims 1 or 2, **characterized in that** the electronic unit (1) further comprises a lid (26), where said mounting means (23) also is arranged for fixing the lid (26) to the housing (3).

4. An electronic unit (1) according to any one of the previous claims, **characterized in that** each electrically conducting surface (22a, 22b) is tin-plated.

5. An electronic unit (1) according to any one of the previous claims, **characterized in that** each contact pin (17, 18) comprises at least one bend.

## Patentansprüche

1. Elektronische Einheit (1), umfassend ein Gehäuse (3) und eine Leiterplatte (2), die so angeordnet ist, dass sie an dem Gehäuse (3) befestigt wird, wobei das Gehäuse (3) wiederum eine erste Wand (4) sowie ein erstes elektrisches Bauteil (15) umfasst, das an einer Innenfläche (12) der ersten Wand (4) befestigt ist, wobei das erste elektrische Bauteil (15) mindestens einen elektrisch leitenden Kontaktstift (17, 18) aufweist, wobei das Gehäuse (3) ferner ein Halteelement (19) für den Kontaktstift (17, 18) umfasst, **dadurch gekennzeichnet, dass** das Halteelement (19) an der Innenfläche (12) angebracht ist und mindestens eine Nut (20, 21) umfasst, die so angeordnet ist, dass sie den Kontaktstift (17, 18) aufnimmt, wobei das Halteelement (19) so angeordnet ist, dass es den Kontaktstift (17, 18) derart hält, dass ein direkter elektrischer Kontakt zwischen dem Kontaktstift (17, 18) und mindestens einer entsprechenden elektrisch leitenden Fläche (22a, 22b) hergestellt ist, die auf der Leiterplatte (2) angeordnet ist, wenn die Leiterplatte (2) an dem Gehäuse (3) befestigt ist, wobei die elektronische Einheit (1) ferner ein Befestigungsmittel (23) umfasst, das so angeordnet ist, dass es den Kontaktstift (17, 18) an der elektrisch leitenden Fläche (22a, 22b) festklemmt.

2. Elektronische Einheit (1) nach Anspruch 1, **dadurch gekennzeichnet, dass** das erste elektrische Bauteil (15) zwei Kontaktstifte (17, 18) umfasst, wobei das Befestigungsmittel (23) zur Platzierung zwischen den Kontaktstiften (17, 18) angeordnet ist.

3. Elektronische Einheit (1) nach Anspruch 1 oder 2, **dadurch gekennzeichnet, dass** die elektronische Einheit (1) ferner einen Deckel (26) umfasst, wobei das Befestigungsmittel (23) auch zum Befestigen des Deckels (26) am Gehäuse (3) vorgesehen ist.

4. Elektronische Einheit (1) nach einem der vorhergehenden Ansprüche, **dadurch gekennzeichnet, dass** jede elektrisch leitende Fläche (22a, 22b) verzinnt ist.

5. Elektronische Einheit (1) nach einem der vorhergehenden Ansprüche, **dadurch gekennzeichnet, dass** jeder Kontaktstift (17, 18) mindestens einen Knick umfasst.

## Revendications

1. Unité électronique (1) comprenant un boîtier (3) et une carte de circuit imprimé (2) agencée pour être montée sur le boîtier (3), le boîtier (3) comprenant pour sa part une première paroi (4) et un premier composant électrique (15) monté sur une surface intérieure (12) de la première paroi (4), le premier composant électrique (15) comportant au moins une broche de contact (17, 18) électriquement conductrice, le boîtier (3) comprenant en outre un élément de support (19) pour ladite broche de contact (17, 18) **caractérisée en ce que** l'élément de support (19) est fixé à la surface intérieure (12) et comprend au moins une rainure (20, 21) agencée pour recevoir ladite broche de contact (17, 18), l'élément de support (19) étant agencé pour supporter ladite broche de contact (17, 18) de sorte qu'un contact électrique direct est établi entre ladite broche de contact (17, 18) et au moins une surface électriquement conductrice (22a, 22b) correspondante agencée sur la carte de circuit imprimé (2) quand la carte de circuit imprimé (2) est montée sur le boîtier (3), l'unité électronique (1) comprenant en outre un moyen de montage (23) agencé pour serrer ladite broche de contact (17, 18) contre ladite surface électriquement conductrice (22a, 22b).

2. Unité électronique (1) selon la revendication 1, **caractérisée en ce que** le premier composant électrique (15) comprend deux broches de contact (17, 18), le moyen de montage (23) étant agencé pour être positionné entre les broches de contact (17, 18).

3. Unité électronique (1) selon l'une quelconque des revendications 1 ou 2, **caractérisée en ce que** l'unité électronique (1) comprend en outre un couvercle (26), ledit moyen de montage (23) étant également agencé pour fixer le couvercle (26) au boîtier (3).

4. Unité électronique (1) selon l'une quelconque des revendications précédentes, **caractérisée en ce que** chaque surface électriquement conductrice (22a, 22b) est étamée.

5. Unité électronique (1) selon l'une quelconque des revendications précédentes, **caractérisée en ce que** chaque broche de contact (17, 18) comprend au moins un coude.
